# EUROPEAN PATENT SPECIFICATION

(11) **EP 4 187 562 B1**
(45) Date of publication and mention of the grant of the patent: **22.04.2026**
(21) Application number: 21855459.0
(22) Date of filing: 06.08.2021
(51) Int. Cl.: H01F 27/28, H01F 1/24, H01F 17/04, H01F 41/02

(54) **POWER INDUCTOR AND PREPARATION METHOD THEREFOR, AND SYSTEM-IN-PACKAGE MODULE**
LEISTUNGSINDUKTOR UND HERSTELLUNGSVERFAHREN DAFÜR SOWIE SYSTEM-IN-PACKAGE-MODUL
INDUCTEUR DE PUISSANCE ET SON PROCÉDÉ DE PRÉPARATION, ET MODULE DE SYSTÈME EN BOÎTIER

(30) Priority: 09.08.2020 CN 202010792435
(43) Date of publication of application: 31.05.2023
(73) Proprietor: Huawei Digital Power Technologies Co., Ltd., Shenzhen, Guangdong 518043 (CN)
(72) Inventor: HU, Xiaoqing, Shenzhen, Guangdong 518129 (CN); ZHI, Yanjun, Shenzhen, Guangdong 518129 (CN); JING, Xiaming, Shenzhen, Guangdong 518129 (CN)
(74) Representative: Isarpatent
(86) International application number: PCT/CN2021/111322
(87) International publication number: WO 2022/033406

(56) References cited:
- EP-B1- 1 080 477
- WO-A1-2010/123019
- CN-A- 1 862 720
- CN-A- 1 862 720
- CN-A- 106 548 851
- CN-A- 107 768 069
- CN-A- 107 768 069
- CN-A- 107 799 260
- CN-A- 109 891 530
- CN-A- 111 243 814
- CN-A- 111 243 814
- CN-A- 112 509 783
- CN-B- 106 158 293
- CN-U- 210 325 447
- CN-U- 210 325 447
- JP-A- 2002 184 634
- JP-A- 2002 184 634
- KR-A- 20180 017 409
- US-A1- 2001 016 977
- US-A1- 2003 141 952
- US-A1- 2014 320 249
- US-A1- 2018 068 775
- US-A1- 2018 144 859
- US-A1- 2019 392 987
- US-A1- 2020 035 413
- US-B1- 9 263 177
- US-B1- 9 263 177
- US-B2- 10 325 715
- US-B2- 6 791 445

## Description

### TECHNICAL FIELD

This disclosure relates to the field of electronic technologies, and the invention relates to a power inductor, and a preparation method of a power inductor.

### BACKGROUND

Rapid development of electronic products requires that an IC component evolves toward a stronger function and a higher degree of integration. However, as the Moore's law of an IC industry gradually approaches a physical limit, further integration of a chip process is greatly challenged, and therefore, a system in package (SiP) module obtained after a plurality of components are integrally packaged is developed. However, an existing SiP module generally integrally plastic-packages components that are tiled and interconnected, and consequently, a space size in a plane direction of the SiP module is difficult to reduce. In addition, export of heat dissipation on the back of the component through a plastic sealant is greatly limited, and for a line connection, heat is only exported by using the bottom of a single surface. This restricts efficient integration and heat dissipation of a product. Therefore, a power system in package (PSiP) module implements high power and miniaturization by increasing a degree of integration of the components in a vertical direction. However, a manner of disposing pins on a same plane of components in a conventional technology cannot match an existing PSiP module of a high degree of integration of the components in the vertical direction.

CN 106 158 293 A relates to a manufacturing method of surface mounted multiphase inductors. The manufacturing method uses a cast mold and seals a plurality of coils using a sealing material mainly composed of resin and magnetic powder. The sealing material is pre-heated in a shape in which flat plate-shaped circumferential edge portions, each having columnar convexity for forming a plurality of tablets. The coil is formed using winding wire. A member is obtained by placing the coil onto the tablet and making both ends of the coil be along the outer side surface of the columnar convex. The outer side surface of the columnar convex is placed in a die groove of the cast mold. Both ends of the coil are sandwiched between the outer side surface of the columnar convexity of the tablet and the inner wall surface of the die groove. A resin molding method or powder compaction molding method is used to make the coil with the integrated sealing material to form a core portion. An external electrode connected with at least a part of both end parts of the coil is provided on the surface or the outer circumference of the core portion. Both end parts of the coil are exposed on the surface of the core portion.

US 9 263 177 B1 relates to pin inductors and associated systems and methods. A magnetic device includes a magnetic core and N windings wound at least partially around respective portions of the magnetic core. Each of the N windings has opposing first and second ends. Each first end forms a first connector, and each second end forms a second connector. Each first connector is adapted for coupling to a first substrate in a first plane, and each second connector is adapted for coupling to a second substrate in a second plane, where the second plane is different from the first plane. N is an integer greater than zero. An electrical assembly includes a substrate and a power supply module, including a magnetic device. The magnetic device at least partially electrically couples the power supply module to the substrate. FIG. 46 shows a scalable pin coupled inductor 4600, wherein each **winding** 4612 has opposing first and second ends 4616, 4618. Each winding first end 4616 forms a respective first solder tab 4620 on magnetic core first outer surface 4304, and a respective second solder tab 4621 on magnetic core second outer surface 4306. Similarly, each **winding** second end 4618 forms a respective first solder tab 4623 on magnetic core first outer surface 4304, and a respective second solder tab 4322 on magnetic core second outer surface 4306.

### SUMMARY

The object of the present invention is to provide a power inductor, and a preparation method of a power inductor, to improve adaptability of the inductor and reduce loss of the inductor. This object is solved by the attached independent claims, and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "... aspect according to an example", "the disclosure describes", or "the disclosure" describe technical teaching which relates to the understanding of the claimed invention or its embodiments.

According to the present invention there is provided a power inductor according to present claim 1.

The invention provides a power inductor, and the power inductor is applied to a system in package module. The power inductor includes a winding and a metal magnetic powder core. The metal magnetic powder core is configured to support the winding, and the winding uses a metal conductive sheet. During assembly, the metal magnetic powder core is integrated with the winding through pressing, the metal magnetic powder core wraps the winding, and the metal magnetic powder core is insulated from the winding. The winding has a first pin and a second pin, and the first pin and the second pin are exposed on different surfaces of the metal magnetic powder core. Pins are separately disposed on two different surfaces of the power inductor, so that the power inductor can match a system in package module in which components are arranged in different directions. Therefore, disposing of the inductor is facilitated. In addition, the winding is formed by integrally pressing the metal conductive sheet and the metal magnetic powder core, so that inductance of the power inductor is increased, loss of the inductor is reduced, and miniaturization of the inductor is improved.

In a specific not-claimed implementable solution, the metal magnetic powder core has a first external surface and a second external surface that are away from each other, the first pin is exposed on the first external surface, and the second pin is exposed on the second external surface. Therefore, adaptability of the power inductor is improved.

According to the invention, the winding includes a body structure and a first connection structure and a second connection structure that are connected to two ends of the body structure in a one-to-one correspondence. The first connection structure includes the first pin, and the second connection structure includes the second pin. The two disposed connection structures are connected to the body structure, and are used as pins of the power inductor.

In a specific not-claimed implementable solution, the first connection structure, the second connection structure, and the body structure are an integrated structure. Therefore, resistance of the winding is reduced.

According to the invention, the second connection structure further includes a third pin, and the third pin and the first pin are located on a same surface. A plurality of pins are formed, so that the inductor has different current paths. The body structure, the first connection structure, and the second connection structure of the winding are completely embedded within the metal magnetic powder core, except for the exposed ends of the first pin, the second pin, and a third pin.

According to the invention, a first current path length is less than a second current path length, the second current path length is a current path length from the first pin to the second pin, and the first current path length is a current path length from the third pin to the second pin. This adapts to different connection scenarios.

In a specific implementable solution, the body structure is Z-shaped, the first connection structure is connected to one end of the Z-shaped body structure, and the second connection structure is connected to the other end of the Z-shaped body structure. Therefore, a space volume occupied by the inductor is reduced.

In a specific not-claimed implementable solution, the body structure may alternatively be different shapes such as an L-shape, an S-shape, or an M-shape. Therefore, different inductance values can be provided.

In a specific implementation solution, the winding is a bare copper sheet formed through stamping. Therefore, resistance of the power inductor and loss of the power inductor are reduced.

In a specific implementable solution, there are a plurality of windings, and the plurality of windings are arranged in a single row. Therefore, modularization is facilitated.

Further according to the present invention there is provided a preparation method of a power inductor according to present claim 5.

In the foregoing technical not-claimed solution, a partial magnetic core is pressed in segments to increase pressure in a process of forming the inductor, so that magnetic permeability of a material of the metal magnetic powder core can be improved, and inductance can be increased, and therefore, miniaturization of the inductor is facilitated. In addition, pins are separately disposed on two different surfaces of the power inductor, so that the power inductor can match a system in package module in which components are arranged in different directions.

In a specific implementable solution, the method further includes: performing high-temperature annealing after the metal magnetic powder core is pressed in segments. High-temperature annealing is performed after pressing, so that loss of a magnetic material is significantly reduced, and overall loss of the inductor is finally reduced, to ensure that the inductor has relatively low operating temperature.

In a specific implementable solution, annealing temperature of the high-temperature annealing is not less than 400°C. Therefore, loss of a magnetic material is reduced, and overall loss of the inductor is finally reduced, to ensure that the inductor has relatively low operating temperature.

In a specific not-claimed implementation, the annealing temperature may be different temperature such as 500°C, 600°C, or 700°C. When the high-temperature annealing is used, loss of a magnetic material is reduced, and overall loss of the inductor is finally reduced.

According to the invention, the pressing the metal magnetic powder core in segments specifically includes: pressing the metal magnetic powder core in two segments; or pressing the metal magnetic powder core in three segments. Pressing may be performed in segments in different manners based on a shape of the winding.

According to a third aspect of the invention, the invention provides a system in package module.

The system in package module includes a circuit board and the power inductor according to any one of the foregoing implementable solutions that is disposed on the circuit board. Pins are separately disposed on two opposite surfaces of the power inductor, so that the power inductor can match a system in package module in which component are arranged in a vertical direction.

### DESCRIPTION OF EMBODIMENTS

The following further describes in detail embodiments of this application with reference to the accompanying drawings.

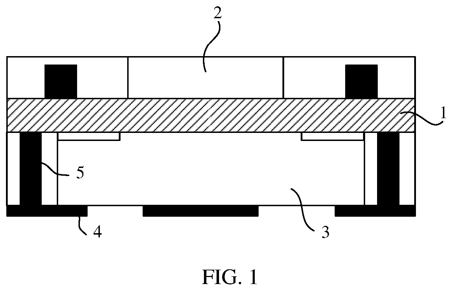

First, an application scenario of an inductor provided in embodiments of this application is described. The inductor may be applied to various electronic components. For example, the inductor may be used as a core component of a power DC/DC converter. The inductor is widely used in fields such as an industrial device, consumer electronics, and chip power supply, and is particularly applied to a package module of a buck converter powered by high-power consumer electronics and a high-current chip. However, for a high-frequency high-current DC/DC power conversion system in package module, because a high degree of integration is required, the inductor needs to be characterized by a small volume, low loss, and high direct-current bias, and needs to meet a requirement for integration of components in a vertical direction. FIG. 1 shows a structure of a system in package module. The system in package module includes a substrate 1, a chip 2 disposed on one surface of the substrate 1, and an inductor 3 disposed on the other opposite surface of the substrate 1. Both the chip 2 and the inductor 3 are electrically connected to a circuit layer of the substrate 1, and both the chip 2 and the inductor 3 are packaged by using a packaging layer. Still refer to FIG. 1. Because a pin 4 is disposed on one surface of the inductor 3, and the pin 4 is disposed on a surface that is of the inductor 3 and that is away from the substrate 1, when the inductor 3 is electrically connected to the substrate 1, the pin 4 needs to be connected to the substrate 1 by disposing a metal through-hole 5 on the packaging layer. A manner of electrically connecting the inductor 3 and the substrate 1 is relatively troublesome. Therefore, an embodiment of this application provides a power inductor. The power inductor provided in embodiments of this application is described in detail below with reference to the accompanying drawings and embodiments.

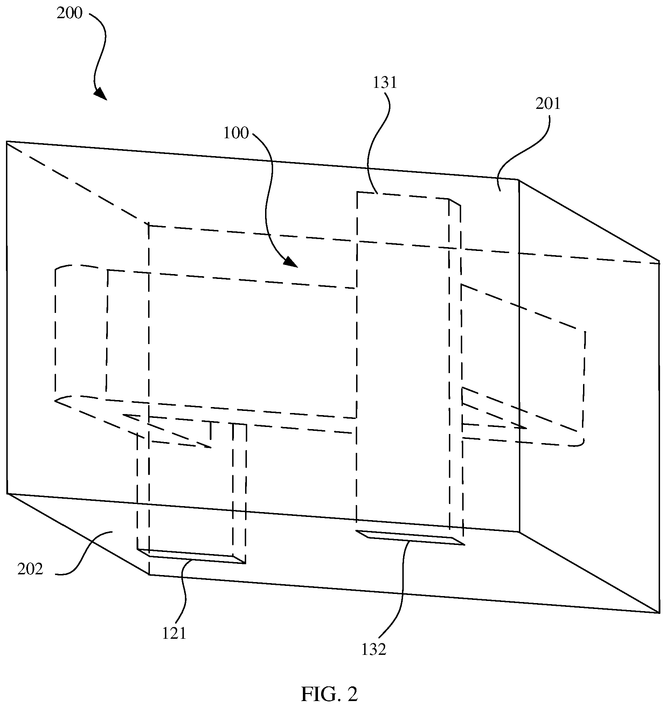

FIG. 2 is a schematic diagram of a three-dimensional structure of a power inductor according to an embodiment of this application. A dashed line in FIG. 2 represents a partial blocked structure outline of the power inductor and an internal outline of the power inductor.

The power inductor may include a winding 100 and a metal magnetic powder core 200. The metal magnetic powder core 200 is a body structure of the power inductor, and a shape of the metal magnetic powder core 200 is a shape of the power inductor. The winding 100 is located in the metal magnetic powder core 200. For example, the winding 100 may be located at a center position of the power inductor, and the metal magnetic powder core 200 is pressed and formed on a periphery of the winding 100 and wraps the winding 100.

During preparation, the metal magnetic powder core 200 is insulated from the winding 100. During preparation of the metal magnetic powder core 200, the metal magnetic powder core 200 is formed by pressing metal magnetic powder, and an external surface of the metal magnetic powder is wrapped with an insulating organic material or an inorganic material, so that there is an insulation layer on a surface of the metal magnetic powder core 200 formed by pressing the metal magnetic powder. When the metal magnetic powder core 200 wraps the winding 100, the insulation layer is in contact with the winding 100, and the metal magnetic powder core 200 is insulated from the winding 100.

The winding 100 has a first pin 121 and a second pin 131, and the first pin 121 and the second pin 131 are exposed on different surfaces of the metal magnetic powder core 200. Different surfaces of the metal magnetic powder core 200 indicate different external surfaces of the metal magnetic powder core 200, such as two adjacent external surfaces or two opposite external surfaces. For example, the first pin 121 and the second pin 131 of the winding 100 are exposed on two opposite external surfaces of the metal magnetic powder core 200, and the two external surfaces are separately used as surfaces on which the power inductor cooperates with other components. For example, the metal magnetic powder core 200 has a first external surface 202 and a second external surface 201. The first external surface 202 and the second external surface 201 are separately the surfaces on which the power inductor cooperates with the other components. With reference to the application scenario shown in FIG. 1, the first external surface 202 may be a surface that cooperates with a substrate, and the second external surface 201 is a surface that is away from the first external surface 202. During assembly, the first pin 121 of the winding 100 is exposed on the first external surface 202, and the second pin 131 is exposed on the second external surface 201. In use, the first pin 121 and the second pin 131 are used as external pins of the power inductor, and a current may flow in from the first pin 121 or the second pin 131, and flow out from the other pin of the winding 100.

According to the present invention, the winding 100 has three pins: the first pin 121, the second pin 131, and a third pin 132. The first pin 121 and the third pin 132 of the winding 100 are located on a same surface (the first external surface 202) of the metal magnetic powder core 200. In use, the first pin 121, the second pin 131, and the third pin 132 are used as external pins of the power inductor, and a current may flow in from one of the first pin 121, the second pin 131, and the third pin 132, and flow out from another pin in the three pins.

When the metal magnetic powder core 200 provided in this embodiment of this application is insulated from and wraps the winding 100, the metal magnetic powder core 200 wraps the winding 100 by using a pressing process. In a pressing process, pressure in a process of forming the inductor may be increased, so that magnetic permeability of the metal magnetic powder core 200 can be improved, inductance of the prepared power inductor is improved, and miniaturization of the power inductor is facilitated. In addition, after the pressing is completed, high-temperature annealing is performed on the metal magnetic powder core 200, so that loss of a magnetic material can be significantly reduced. Therefore, temperature at which the power inductor works is reduced, and the power inductor may be disposed at a position that is in a system in package module and that is relatively far away from a heat dissipation apparatus.

In an optional solution, the metal magnetic powder core 200 is in a cuboid structure. However, it should be understood that FIG. 2 is only a specific example of a magnetic powder core. The metal magnetic powder core 200 provided in this embodiment of this application may be pressed into different shapes such as a cylinder, a cylindroid, a cube, or a trapezoid based on a requirement. A specific shape only needs to adapt to assemble space of the power inductor.

The metal magnetic powder core 200 is a magnetic core made of metal alloy powder with low magnetic core loss at a high frequency. There are uniformly distributed air gaps inside the metal magnetic powder core 200, so that magnetic flux is not leaked, and the metal magnetic powder core 200 is not prone to saturation at a high direct current. Therefore, the power inductor prepared by using the metal magnetic powder core 200 is characterized by a high current, a high frequency, miniaturization, and the like.

The metal magnetic powder core 200 may be prepared by using different types of materials, for example, different types of metal magnetic powder cores such as an iron powder core, an iron-silicon-aluminum magnetic core, a high magnetic flux powder core, and a molybdenum permol magnetic powder core. Compositions of the iron powder core are a combination of extremely fine iron powder and an organic material. Magnetic permeability of the iron powder core is between 10 and 75. Compositions of the iron-silicon-aluminum magnetic core are iron that accounts for 85%, silicon that accounts for 9%, and aluminum that accounts for 6%. The iron-silicon-aluminum magnetic core is relatively low in loss and hard in material, and magnetic permeability of the iron-silicon-aluminum magnetic core may be 26, 60, 75, 90, 125, or the like. The high magnetic flux powder core is an iron-nickel magnetic powder core, and alloy powder of the high magnetic flux powder core may include nickel that accounts for 50% and iron that accounts for 50%. The high magnetic flux powder core has the highest magnetic flux density. Loss of the high magnetic flux powder core is higher than that of the iron-silicon-aluminum magnetic core and lower than that of the iron magnetic core. Magnetic permeability of the high magnetic flux powder core is in a range from 14 to 200. Compositions of the molybdenum permol magnetic powder core are molybdenum that accounts for 2%, nickel that accounts for 81%, and iron that accounts for 17%. In the foregoing magnetic powder cores, the molybdenum permol magnetic powder core has the lowest loss and the lowest saturation magnetic flux density. In addition, the molybdenum permol magnetic powder core has good temperature stability and magnetic permeability is in a range from 14 to 550. In an optional solution, metal magnetic powder of the metal magnetic powder core 200 provided in this embodiment of this application may be prepared by using a material including iron silicon, iron silicon aluminum, iron silicon chromium, and iron silicon aluminum nickel. An outer layer of the metal magnetic powder is warped by an insulation layer, and may be specifically prepared by using an organic material or an inorganic material. For example, the organic material may use lipid such as epoxy resin, and the inorganic material may use lipid such as silicon resin.

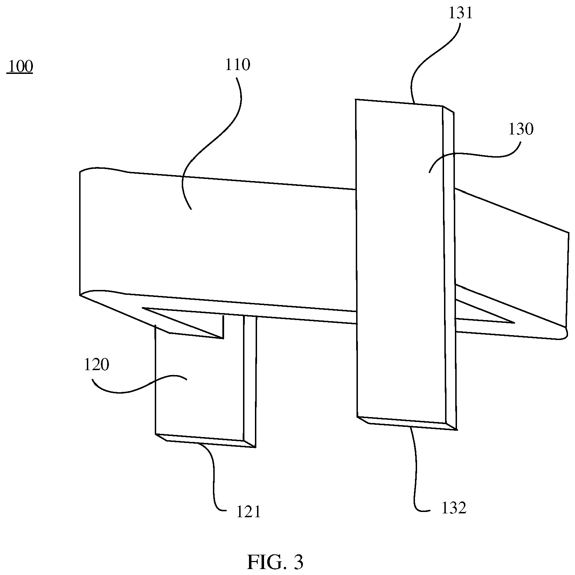

FIG. 3 is a schematic diagram of a structure of the winding according to an embodiment of this application. The winding 100 is a metal conductive sheet prepared by using a conductive metal material, such as a metal material having good conductivity such as copper or aluminum. For example, the winding 100 uses a bare copper sheet formed through stamping, and is different from a winding made of an enamelled wire. The bare copper sheet has good conductivity and relatively low resistance. When used in the power inductor, the winding 100 can reduce heat generated by the power inductor, and has a relatively low heat dissipation effect. Therefore, the winding 100 may be assembled at a position that is in a system in package module and that is relatively far away from a heat dissipation apparatus.

The winding 100 includes a body structure 110 and connection structures. The connection structures provided in this embodiment of this application include a first connection structure 120 and a second connection structure 130. The first connection structure 120 and the second connection structure 130 are located at two ends of the body structure 110, and the first connection structure 120 and the second connection structure 130 are connected to the two ends of the body structure 110 in a one-to-one correspondence. It should be understood that a connection provided in this embodiment of this application may include different connection manners such as welding, an electrical connection, or integrated forming. In an optional solution, the first connection structure 120, the second connection structure 130, and the body structure 110 are prepared by using an integrated forming process. For example, the winding 100 may be formed by stamping a copper sheet, or may be formed after performing processing after stamping, and the first connection structure 120, the second connection structure 130, and the body structure 110 are an integrated structure.

The first connection structure 120 extends to the first external surface of the metal magnetic powder core, and the first connection structure 120 extends to an end of the first external surface as the first pin 121. The second connection structure 130 extends to the second external surface of the metal magnetic powder core, and the second connection structure 130 extends to an end of the second external surface as the second pin 131. The first pin 121 and the second pin 131 are pins at which the power inductor is connected to a cooperating device. The first pin 121 and the second pin 131 are located on two surfaces the power inductor that are away from each other, so that a vertical power supply requirement can be met, and a power supply path can be shortened. Therefore, the power inductor may be applied to a system in package module in a vertical layout, so that adaptability of the power inductor is improved.

In an optional solution, the first connection structure 120, the second connection structure 130, and the body structure 110 are plate-shaped structures. During preparation, the first connection structure 120, the second connection structure 130, and the body structure 110 may be formed through pressing, or integrally formed by pouring a mold.

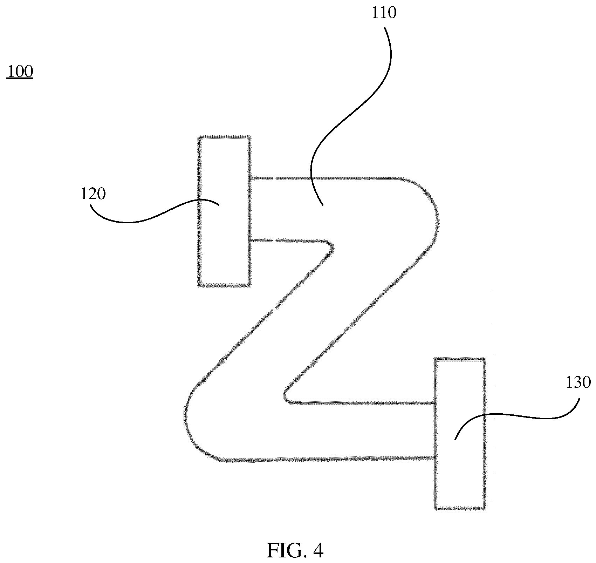

Refer to FIG. 4 together. FIG. 4 is a top view of the winding. The body structure 110 is Z-shaped, the first connection structure 120 is connected to one end of the Z-shaped body structure 110, and the second connection structure 130 is connected to the other end of the Z-shaped body structure 110. When the foregoing structure is used, the body structure 110 is bent to form a Z-shape, so that a space volume occupied by the body structure 110 can be reduced, and a longer winding 100 can be accommodated in the metal magnetic powder core. With reference to the three-dimensional diagram of the power inductor shown in FIG. 2, when the body structure 110 is bent to form the Z-shape, the power inductor may use a smaller volume while inductance is the same. In addition, the body structure uses a Z-shaped structure, so that the power inductor has more uniform magnetic density and larger inductance.

It should be understood that the winding shown in FIG. 3 and FIG. 4 is merely a specific example of the winding provided in this embodiment of this application. The winding provided in this embodiment of this application may alternatively use another shape. For example, the body structure of the winding may alternatively use another shape such as an L-shape, an S-shape, or an M-shape.

In an optional solution, a length direction of the first connection structure 120 and a length direction of the second connection structure 130 are perpendicular to a length direction of the body structure 110. When the metal magnetic powder core wraps the winding 100, the length direction of the first connection structure 120 and the length direction of the second connection structure 130 are perpendicular to the first external surface and the second external surface, and the length direction of the body structure 110 is parallel to the first external surface and the second external surface. When the metal magnetic powder core is pressed, the length direction of the body structure 110 is parallel to the first external surface and the second external surface, so that placement of the winding 100 is facilitated, and production efficiency is improved.

It should be understood that the foregoing manner of disposing the winding 100 is merely a specific example provided in this embodiment of this application. In the winding 100 provided in this embodiment of this application, a manner in which an included angle of the length direction of the body structure 110 and the length direction of the first connection structure 120 and the second connection structure 130 is an acute angle may also be used. However, regardless of a used form, the winding 100 may be applied to this embodiment of this application provided that the winding 100 can be wrapped by the metal magnetic powder core.

Still refer to FIG. 3. In an optional solution, the second connection structure 130 further extends to the first external surface of the metal magnetic powder core, and the second connection structure 130 extends to the end of the first external surface as the third pin 132. The first pin 121 and the third pin 132 are located on a same side and are arranged at intervals. The second pin 131 is located on the opposite side, and all the three pins may be used as connection ends of the winding 100. With reference to the three-dimensional structure of the power inductor shown in FIG. 2, the third pin 132 formed by using the second connection structure 130 adds a pin at which the power inductor is connected to the cooperating component, and the first pin 121 and the third pin 132 are arranged at intervals on the first external surface, and both may be connected to the pin cooperating with the power inductor. When different pins of the power inductor are selected to be connected to the cooperating component, power inductors with different inductance values can be formed.

Different current paths in the power inductor are described below with reference to the accompanying drawings. For convenience of describing the current path, a flowing direction of a current is shown by a straight line with an arrow, but the current in the current path may also flow in a reverse direction of the direction shown by the arrow.

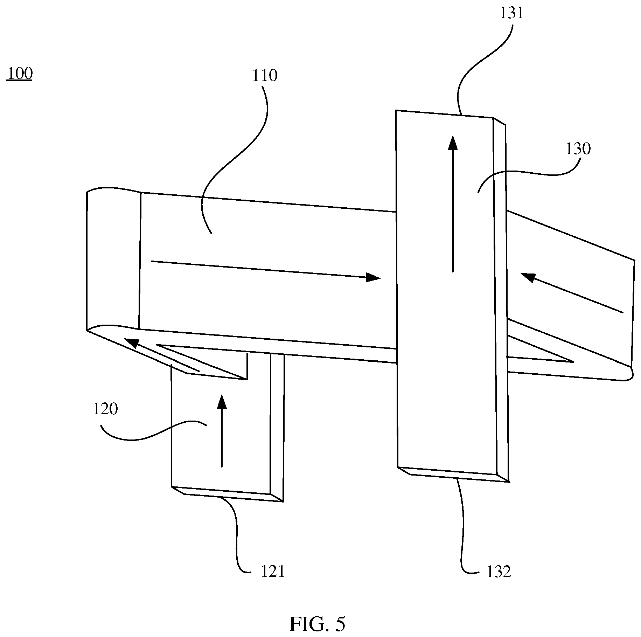

FIG. 5 is a schematic diagram of a current in the winding in one connecting manner of pins of the power inductor. When the first pin 121 and the second pin 131 of the power inductor are separately connected to the cooperating component, a current flows in from the first pin 121 of the first connection structure 120, flows through a part of the first connection structure 120, the body structure 110, and the second connection structure 130, and then flows out from the second pin 131. For ease of description, a length of the foregoing path through which the current flows is referred to as a second current path length.

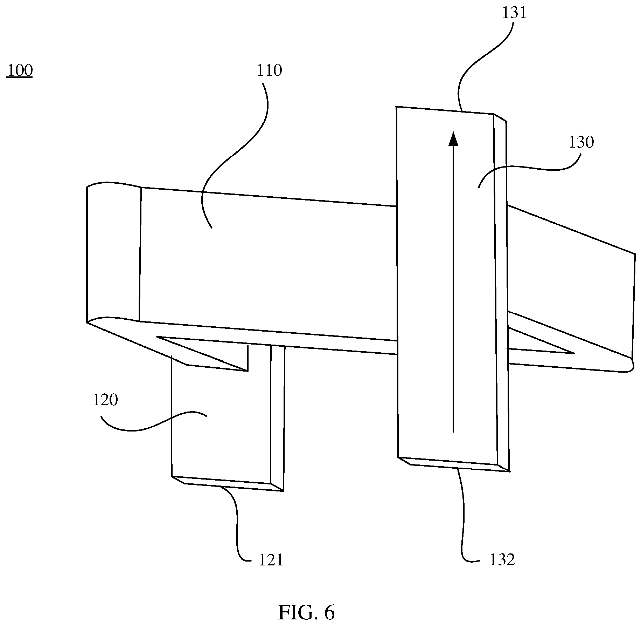

FIG. 6 is a schematic diagram of a current in the winding in another connecting manner of pins of the power inductor. When the third pin 132 and the second pin 131 of the power inductor are separately connected to the cooperating component, a current flows in from the third pin 132 of the second connection structure 130, and flows out from the second pin 131 after flowing through only the second connection structure 130. For ease of description, a length of the foregoing path through which the current flows is referred to as a first current path length.

It may be learned from comparison between FIG. 5 and FIG. 6 that the first current path length is less than the second current path length. Therefore, the power inductor provided in this embodiment of this application can provide different inductance values when different pins are selected to cooperate with another component.

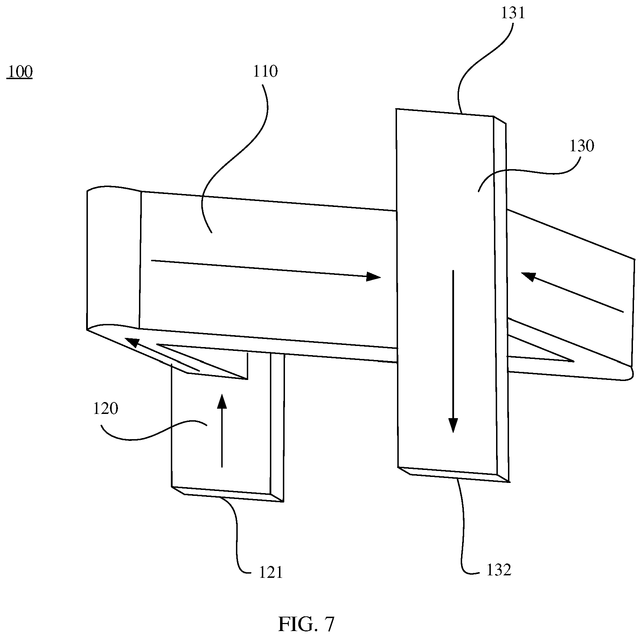

FIG. 7 is a schematic diagram of a current in the winding in another connecting manner of pins of the power inductor. When the first pin 121 and the third pin 132 of the power inductor are separately connected to the cooperating component, a current flows in from the first pin 121 of the first connection structure 120, flows through a part of the first connection structure 120, the body structure 110, and the second connection structure 130, and then flows out from the third pin 132 of the second connection structure 130. It may be learned from FIG. 7 that the power inductor provided in this embodiment of this application may alternatively be connected to the cooperating component by using pins on a same surface.

It may be learned from FIG. 5, FIG. 6, and FIG. 7 that when the power inductor uses the first pin 121, the third pin 132, and the second pin 131, the power inductor may be applicable to different working scenarios, that is, may be applicable to separately connecting to different components by using pins on two end surfaces, and may also be used in a scenario in which the power inductor only needs to be connected to the component by using pins on a same surface. Therefore, applicability of the power inductor is significantly improved.

It should be understood that a quantity of first pins on the first external surface provided in this embodiment of this application may be different quantities such as one, two, or three. Similarly, a quantity of second pins on the second external surface may also be different quantities such as one, two, or three. The quantity of first pins and the quantity of second pins may be specifically set based on a requirement of the power inductor.

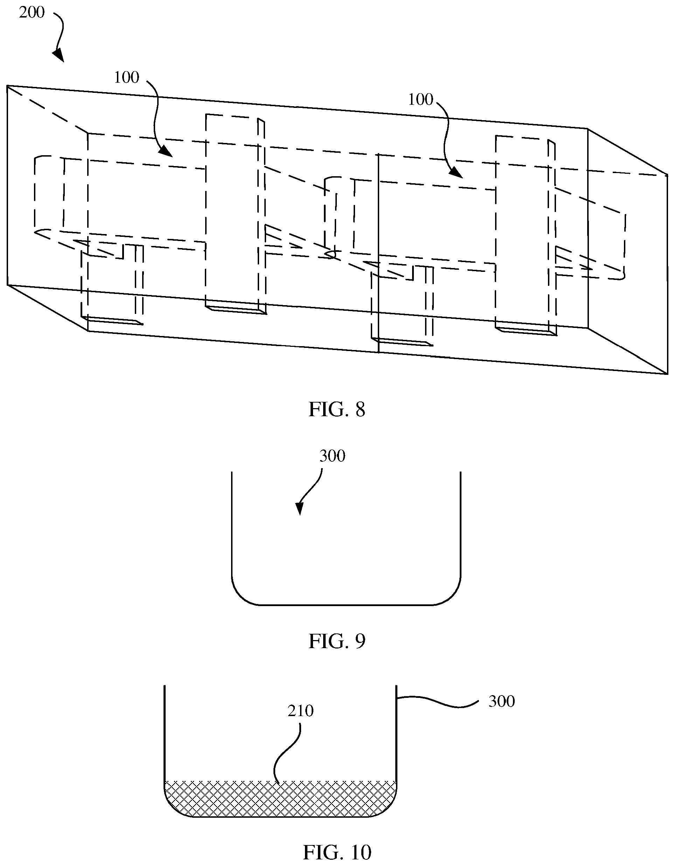

FIG. 8 is a schematic diagram of a structure of another power inductor according to an embodiment of this application. For some reference numerals in FIG. 8, refer to the same reference numerals in FIG. 2. The power inductor shown in FIG. 8 is an integrated power inductor group, and the power inductor group includes a plurality of windings 100. In FIG. 8, two windings 100 are shown as an example. It should be understood that the power inductor provided in this embodiment of this application may include different quantities of windings 100, such as two, three, four, or five windings 100.

The windings 100 may be arranged based on an application scenario of the windings 100. For example, the plurality of windings 100 may be arranged in different arrangement manners, such as array arrangement, single-row arrangement, or triangular arrangement.

In an optional solution, the plurality of windings 100 share the metal magnetic powder core 200. In other words, when the metal magnetic powder core 200 is pressed, the plurality of windings 100 may be insulated and wrapped simultaneously, so that modularization of the power inductor is facilitated. In addition, two-phase or multi-phase power inductor integration helps reduce a component volume, and helps implement a requirement of a system in package module with high integration in a vertical direction.

To facilitate understanding of the structure of the power inductor provided in this embodiment of this application, a preparation method of the power inductor is described in detail below with reference to the accompanying drawings.

The preparation method includes the following steps.

Step 001: Press a first segment of metal magnetic powder core.

As shown in FIG. 9, a mold 300 is prepared, and the mold 300 is configured to press a power inductor. As shown in FIG. 10, the metal magnetic powder core is pressed in a plurality of segments. First, the first segment 210 of metal magnetic powder core that needs to be pressed is placed in the mold 300. The metal magnetic powder core may use a material such as iron silicon, iron silicon aluminum, iron silicon chromium, or iron silicon aluminum nickel.

Step 002: In a process of pressing the metal magnetic powder core in segments, fill a winding into the metal magnetic powder core.

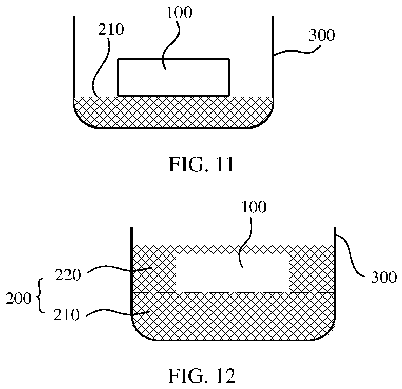

As shown in FIG. 11, a winding 100 is placed in the mold 300, and when the winding 100 is placed, it should be ensured that the winding 100 is partially exposed on a first external surface of the metal magnetic powder core and is used as a first pin, and is partially exposed on a second external surface of the metal magnetic powder core and is used as a second pin. The winding 100 uses a bare copper sheet, and is different from a winding made of an enamelled wire. The bare copper sheet may be formed by stamping a copper sheet, or may be formed by performing processing after pressing. In addition, in addition to that the first pin and the second pin are separately located on a first external surface and a second external surface shown in FIG. 11, the first pin and the second pin may alternatively be located on different surfaces of the metal magnetic powder core, for example, on two adjacent surfaces.

Step 003: Press a remaining metal magnetic powder core.

Specifically, as shown in FIG. 12, metal magnetic powder is placed in the mold 300. The metal magnetic powder wraps the winding 100, and a second segment 220 of metal magnetic powder core is pressed, so that the winding 100 is insulated from and wrapped in the metal magnetic powder core 200.

Step 004: After the metal magnetic powder core is pressed in segments, perform high-temperature annealing.

Specifically, high-temperature annealing is performed after pressing, to form a power inductor. During high-temperature annealing, annealing temperature of the high-temperature annealing is not less than 400°C, and for example, the annealing temperature may be different temperature such as 500°C, 600°C, or 700°C. When the high-temperature annealing is used, loss of a magnetic material is reduced, and overall loss of the inductor is finally reduced, to ensure that the inductor has relatively low operating temperature.

It can be learned from the foregoing descriptions that, in a process of pressing the power inductor, the metal magnetic powder core is pressed in segments based on a shape of the winding. For example, the metal magnetic powder core can be pressed in two segments, or the metal magnetic powder core can be pressed in three segments. For example, when the metal magnetic powder core is pressed in two segments, a lower part of the metal magnetic powder core may be pressed first, and then an upper part of the metal magnetic powder core is pressed. When the metal magnetic powder core is pressed in three segments, an upper part and a lower part of the metal magnetic powder core may be pressed first, and then a middle part of the metal magnetic powder core is pressed.

In addition, when the foregoing segmented pressing process is used, pressure in the process of forming the power inductor may be increased, magnetic permeability of a material of the metal magnetic powder core can be improved, and inductance of the metal magnetic powder core can be improved. Therefore, under a condition of same inductance, miniaturization of the power inductor is facilitated.

An embodiment of this application further provides a system in package module. The system in package module is a packaging manner in which all or a majority of electronic functions of a system or subsystem are configured on an integrated substrate and a chip is bonded to the integrated substrate. The system in package module may not only be assembled with a plurality of chips, but also be installed on a same substrate as a dedicated processor, a dynamic random access memory, a flash memory, and a passive component in combination with a resistor, a capacitor, a connector, an antenna, and the like. The system in package module provided in this embodiment of this application includes a circuit board and a power inductor disposed in any one of the foregoing descriptions that is disposed on the circuit board. Pins are separately disposed on two opposite surfaces of the power inductor, so that the power inductor can match a system in package module in which components are arranged in a vertical direction. Therefore, disposing of the power inductor is facilitated. In addition, in the foregoing power inductor, a degree of integration of components in a vertical direction of the system in package module can be increased, to implement high power and miniaturization of the system in package module.

It is clearly that a person skilled in the art can make various modifications and variations to this application without departing from the scope of this application. This application is intended to cover these modifications and variations of this application provided that they fall within the scope of protection defined by the following claims.

## Claims

1. A power inductor, comprising a winding (100) and a metal magnetic powder core (200), wherein
the metal magnetic powder core (200) wraps the winding (100), and the metal magnetic powder core (200) is insulated from the winding (100);
the winding (100) is a metal conductive sheet, the winding (100) has a first pin (121) and a second pin (131), and the first pin (121) and the second pin (131) are exposed on different surfaces of the metal magnetic powder core (200); and
wherein the winding (100) comprises a body structure (110) and a first connection structure (120) and a second connection structure (130) that are connected to two ends of the body structure (110) in a one-to-one correspondence;
the first connection structure (120) comprises the first pin (121); and
the second connection structure (130) comprises the second pin (131);
wherein the second connection structure (130) further comprises a third pin (132); and
the third pin (132) and the first pin (121) are located with the ends thereof on the same surface;
wherein the body structure (110), the first connection structure (120), and the second connection structure (130) of the winding (100) are completely embedded within the metal magnetic powder core (200), except for the exposed ends of the first pin (121), the second pin (131), and the third pin (132);
wherein a first current path length is less than a second current path length;
the second current path length is a current path length from the first pin (121) to the second pin (131); and
the first current path length is a current path length from the third pin (132) to the second pin (131).

2. The power inductor according to claim 1, wherein the body structure (110) is Z-shaped;
the first connection structure (120) is connected to one end of the Z-shaped body structure (110); and
the second connection structure (130) is connected to the other end of the Z-shaped body structure (110).

3. The power inductor according to any one of claims 1 to 2, wherein the winding (100) is a bare copper sheet formed through stamping.

4. The power inductor according to any one of claims 1 to 3, wherein the winding (100) comprises a plurality of windings (100), each winding (100) being a metal conductive sheet, and the plurality of windings (100) are arranged in a single row wrapped and insulated by the metal magnetic powder core (200).

5. A preparation method of a power inductor, comprising the following steps:
pressing a metal magnetic powder core (200) in segments;
filling a winding (100) into the metal magnetic powder core (200) in a process of pressing the metal magnetic powder core (200) in segments, wherein
the winding (100) is a metal conductive sheet, the winding (100) has a first pin (121), a second pin (131), and a third pin (132), and the first pin (121) and the second pin (131) are exposed on different surfaces of the metal magnetic powder core (200); and
wherein the winding (100) comprises a body structure (110) and a first connection structure (120) and a second connection structure (130) that are connected to two ends of the body structure (110) in a one-to one correspondence;
the first connection structure (120) comprises the first pin (121); and the second connection structure (130) comprises the second pin (131) and the third pin (132);
wherein the pressing a metal magnetic powder core (200) in segments specifically comprises:
pressing the metal magnetic powder core (200) in two segments; or
pressing the metal magnetic powder core (200) in three segments;
wherein pressing the metal magnetic powder core (200) in two segments includes:
pressing a lower part of the metal magnetic powder core (200) first; and
pressing an upper part of the metal magnetic powder core (200);
wherein the third pin (132) and the first pin (121) are located with the ends thereof on the same surface;
wherein, after the filling step, the body structure (110), the first connection structure (120), and the second connection structure (130) of the winding (100) are completely embedded within the metal magnetic powder core (200), except for the exposed ends of the first pin (121), the second pin (131), and the third pin (132);
wherein a first current path length is less than a second current path length;
wherein the second current path length is a current path length from the first pin (121) to the second pin (131); and
wherein the first current path length is a current path length from the third pin (132) to the second pin (131).

6. The preparation method according to claim 5, further comprising: performing high-temperature annealing after the metal magnetic powder core (200) is pressed in segments.

7. The preparation method according to claim 6, wherein an annealing temperature of the high-temperature annealing is not less than 400°C.

8. A system in package module, comprising a circuit board and the power inductor according to any one of claims 1 to 4 that is disposed on the circuit board.

## Patentansprüche

1. Leistungsinduktor, umfassend eine Wicklung (100) und einen magnetischen Metallpulverkern (200), wobei
der magnetische Metallpulverkern (200) die Wicklung (100) umhüllt, und der magnetische Metallpulverkern (200) von der Wicklung (100) isoliert ist;
die Wicklung (100) ein leitendes Metallblech ist, die Wicklung (100) einen ersten Stift (121) und einen zweiten Stift (131) aufweist und der erste Stift (121) und der zweite Stift (131) auf unterschiedlichen Oberflächen des magnetischen Metallpulverkerns (200) freiliegen; und
wobei die Wicklung (100) eine Körperstruktur (110) und eine erste Verbindungsstruktur (120) und eine zweite Verbindungsstruktur (130) umfasst, die mit zwei Enden der Körperstruktur (110) in einer Eins-zu-Eins-Entsprechung verbunden sind;
die erste Verbindungsstruktur (120) den ersten Stift (121) umfasst; und
die zweite Verbindungsstruktur (130) den zweiten Stift (131) umfasst;
wobei die zweite Verbindungsstruktur (130) ferner einen dritten Stift (132) umfasst; und
der dritte Stift (132) und der erste Stift (121) mit ihren Enden auf der gleichen Oberfläche liegen;
wobei die Körperstruktur (110), die erste Verbindungsstruktur (120) und die zweite Verbindungsstruktur (130) der Wicklung (100) mit Ausnahme der freiliegenden Enden des ersten Stifts (121), des zweiten Stifts (131) und des dritten Stifts (132) vollständig in den magnetischen Metallpulverkern (200) eingebettet sind;
wobei eine erste Strompfadlänge kleiner ist als eine zweite Strompfadlänge;
die zweite Strompfadlänge eine Strompfadlänge von dem ersten Stift (121) zu dem zweiten Stift (131) ist; und
die erste Strompfadlänge eine Strompfadlänge von dem dritten Stift (132) zu dem zweiten Stift (131) ist.

2. Leistungsinduktor nach Anspruch 1, wobei die Körperstruktur (110) Z-förmig ist;
die erste Verbindungsstruktur (120) mit einem Ende der Z-förmigen Körperstruktur (110) verbunden ist; und
die zweite Verbindungsstruktur (130) mit dem anderen Ende der Z-förmigen Körperstruktur (110) verbunden ist.

3. Leistungsinduktor nach einem der Ansprüche 1 bis 2, wobei die Wicklung (100) ein blankes, durch Stanzen geformtes Kupferblech ist.

4. Leistungsinduktor nach einem der Ansprüche 1 bis 3, wobei die Wicklung (100) eine Vielzahl von Wicklungen (100) umfasst, wobei jede Wicklung (100) ein leitendes Metallblech ist und die Vielzahl von Wicklungen (100) in einer einzigen Reihe angeordnet sind, die von dem magnetischen Metallpulverkern (200) umhüllt und isoliert ist.

5. Herstellungsverfahren für einen Leistungsinduktor, umfassend die folgenden Schritte:
segmentweises Pressen eines magnetischen Metallpulverkerns (200);
Füllen einer Wicklung (100) in den magnetischen Metallpulverkern (200) in einem Prozess des segmentweisen Pressens des magnetischen Metallpulverkerns (200), wobei
die Wicklung (100) ein leitendes Metallblech ist, die Wicklung (100) einen ersten Stift (121), einen zweiten Stift (131) und einen dritten Stift (132) aufweist und der erste Stift (121) und der zweite Stift (131) auf unterschiedlichen Oberflächen des magnetischen Metallpulverkerns (200) freiliegen; und
wobei die Wicklung (100) eine Körperstruktur (110) und eine erste Verbindungsstruktur (120) und eine zweite Verbindungsstruktur (130) umfasst, die mit zwei Enden der Körperstruktur (110) in einer Eins-zu-Eins-Entsprechung verbunden sind; die erste Verbindungsstruktur (120) den ersten Stift (121) umfasst; und die zweite Verbindungsstruktur (130) den zweiten Stift (131) und den dritten Stift (132) umfasst;
wobei das segmentweise Pressen eines magnetischen Metallpulverkerns (200) insbesondere Folgendes umfasst:
Pressen des magnetischen Metallpulverkerns (200) in zwei Segmenten; oder
Pressen des magnetischen Metallpulverkerns (200) in drei Segmenten;
wobei das Pressen des magnetischen Metallpulverkerns (200) in zwei Segmenten Folgendes beinhaltet:
Pressen eines unteren Teils des magnetischen Metallpulverkerns (200) zuerst; und
Pressen eines oberen Teils des magnetischen Metallpulverkerns (200);
wobei der dritte Stift (132) und der erste Stift (121) mit ihren Enden auf der gleichen Oberfläche liegen;
wobei die Körperstruktur (110), die erste Verbindungsstruktur (120) und die zweite Verbindungsstruktur (130) der Wicklung (100) nach dem Füllschritt mit Ausnahme der freiliegenden Enden des ersten Stifts (121), des zweiten Stifts (131) und des dritten Stifts (132) vollständig in den magnetischen Metallpulverkern (200) eingebettet sind;
wobei eine erste Strompfadlänge kleiner ist als eine zweite Strompfadlänge;
wobei die zweite Strompfadlänge eine Strompfadlänge von dem ersten Stift (121) zu dem zweiten Stift (131) ist; und
wobei die erste Strompfadlänge eine Strompfadlänge von dem dritten Stift (132) zu dem zweiten Stift (131) ist.

6. Herstellungsverfahren nach Anspruch 5, ferner umfassend: Durchführen einer Hochtemperaturglühung, nachdem der metallische Magnetpulverkern (200) segmentweise gepresst wurde.

7. Herstellungsverfahren nach Anspruch 6, wobei die Glühtemperatur der Hochtemperaturglühung nicht unter 400 °C ist.

8. System-in-Package-Modul, umfassend eine Leiterplatte und den Leistungsinduktor nach einem der Ansprüche 1 bis 4, der auf der Leiterplatte angeordnet ist.

## Revendications

1. Inductance de puissance, comprenant un enroulement (100) et un noyau de poudre magnétique métallique (200), dans laquelle
le noyau de poudre magnétique métallique (200) enveloppe l'enroulement (100), et le noyau de poudre magnétique métallique (200) est isolé de l'enroulement (100) ;
l'enroulement (100) est une feuille conductrice métallique, l'enroulement (100) a une première broche (121) et une deuxième broche (131), et la première broche (121) et la deuxième broche (131) sont exposées sur différentes surfaces du noyau de poudre magnétique métallique (200) ; et
dans laquelle l'enroulement (100) comprend une structure de corps (110) et une première structure de connexion (120) et une seconde structure de connexion (130) qui sont connectées aux deux extrémités de la structure de corps (110) dans une correspondance biunivoque ;
la première structure de connexion (120) comprend la première broche (121) ; et
la seconde structure de connexion (130) comprend la deuxième broche (131) ;
dans laquelle la seconde structure de connexion (130) comprend également une troisième broche (132) ; et
la troisième broche (132) et la première broche (121) sont situées avec leurs extrémités sur la même surface ;
dans lequel la structure de corps (110), la première structure de connexion (120) et la seconde structure de connexion (130) de l'enroulement (100) sont complètement intégrées au sein du noyau de poudre magnétique métallique (200), à l'exception des extrémités exposées de la première broche (121), de la deuxième broche (131) et de la troisième broche (132) ;
dans laquelle une première longueur de chemin de courant est inférieure à une seconde longueur de chemin de courant ;
la seconde longueur de chemin de courant est la longueur de chemin de courant de la première broche (121) à la deuxième broche (131) ; et
la première longueur de chemin de courant est une longueur de chemin de courant de la troisième broche (132) à la deuxième broche (131).

2. Inductance de puissance selon la revendication 1, dans laquelle la structure de corps (110) est en forme de Z ;
la première structure de connexion (120) est connectée à une extrémité de la structure de corps (110) en forme de Z ; et
la seconde structure de connexion (130) est connectée à l'autre extrémité de la structure de corps (110) en forme de Z.

3. Inductance de puissance selon l'une quelconque des revendications 1 à 2, dans laquelle l'enroulement (100) est une feuille de cuivre nue formée par estampage.

4. Inductance de puissance selon l'une quelconque des revendications 1 à 3, dans laquelle l'enroulement (100) comprend une pluralité d'enroulements (100), chaque enroulement (100) étant une feuille conductrice métallique, et la pluralité d'enroulements (100) sont agencés en une seule rangée enveloppée et isolée par le noyau de poudre magnétique métallique (200).

5. Procédé de préparation d'une inductance de puissance, comprenant les étapes suivantes :
pressage d'un noyau de poudre magnétique métallique (200) en segments ;
remplissage d'un enroulement (100) dans le noyau de poudre magnétique métallique (200) dans un processus de pressage du noyau de poudre magnétique métallique (200) en segments, dans lequel
l'enroulement (100) est une feuille conductrice métallique, l'enroulement (100) a une première broche (121), une deuxième broche (131), et une troisième broche (132), et la première broche (121) et la deuxième broche (131) sont exposées sur différentes surfaces du noyau de poudre magnétique métallique (200) ; et
dans lequel l'enroulement (100) comprend une structure de corps (110) et une première structure de connexion (120) et une seconde structure de connexion (130) qui sont connectées aux deux extrémités de la structure de corps (110) dans une correspondance biunivoque ;
la première structure de connexion (120) comprend la première broche (121) ; et la seconde structure de connexion (130) comprend la deuxième broche (131) et la troisième broche (132) ; dans lequel le pressage d'un noyau de poudre magnétique métallique (200) en segments comprend spécifiquement :
le pressage du noyau de poudre magnétique métallique (200) en deux segments ; ou
le pressage du noyau de poudre magnétique métallique (200) en trois segments ;
dans lequel le pressage du noyau de poudre magnétique métallique (200) en deux segments comporte :
le pressage d'une partie inférieure du noyau de poudre magnétique métallique (200) d'abord ; et
le pressage d'une partie supérieure du noyau de poudre magnétique métallique (200) ;
dans lequel la troisième broche (132) et la première broche (121) sont situées avec leurs extrémités sur la même surface ;
dans lequel, après l'étape de remplissage, la structure de corps (110), la première structure de connexion (120) et la seconde structure de connexion (130) de l'enroulement (100) sont complètement intégrées au sein du noyau de poudre magnétique métallique (200), à l'exception des extrémités exposées de la première broche (121), de la deuxième broche (131) et de la troisième broche (132) ;
dans lequel une première longueur de chemin de courant est inférieure à une seconde longueur de chemin de courant ;
dans lequel la seconde longueur de chemin de courant est la longueur de chemin de courant de la première broche (121) à la deuxième broche (131) ; et
dans lequel la première longueur de chemin de courant est une longueur de chemin de courant de la troisième broche (132) à la deuxième broche (131).

6. Procédé de préparation selon la revendication 5, comprenant également : la réalisation d'un recuit à haute température après que le noyau de poudre magnétique métallique (200) est pressé en segments.

7. Procédé de préparation selon la revendication 6, dans lequel une température de recuit du recuit à haute température n'est pas inférieure à 400 °C.

8. Module de système dans un boîtier, comprenant une carte de circuit et l'inductance de puissance selon l'une quelconque des revendications 1 à 4 qui est disposée sur la carte de circuit.
